# FASCICULE DE BREVET EUROPEEN

(11) **EP 2 158 602 B1**
(45) Date de publication et mention de la délivrance du brevet: **21.03.2012**
(21) Numéro de dépôt: 08736435.2
(22) Date de dépôt: 21.04.2008
(51) Int. Cl.: H01L 21/677, H01L 21/673

(54) **INTERFACE D'ENCEINTE DE TRANSPORT**
TRANSPORT-POD-SCHNITTSTELLE
TRANSPORT POD INTERFACE

(30) Priorité: 04.05.2007 FR 0754852
(43) Date de publication de la demande: 03.03.2010
(73) Titulaire: Adixen Vacuum Products, 74000 Annecy (FR)
(72) Inventeur: GODOT, Erwan, F-74000 Annecy (FR)
(74) Mandataire: Croonenbroek, Thomas Jakob
(86) Numéro de dépôt international: PCT/EP2008/054824
(87) Numéro de publication internationale: WO 2008/135377

(56) Documents cités:
- WO-A-2006/030849
- JP-A- 5 109 862
- US-A- 5 697 750

## Description

La présente invention concerne une interface d'enceinte de transport et/ou de stockage de substrats de microsystèmes électromécaniques MEMS (« Micro-Electro-Mechanical Systems » en anglais) ou de semi-conducteurs tels que des plaquettes (« wafers » en anglais) ou des masques.

L'invention concerne également un dispositif d'analyse tel qu'une station d'analyse ou une chambre d'entrée/sortie d'équipement de fabrication semi-conducteur comprenant au moins une interface pour la mesure et le contrôle de l'atmosphère interne des enceintes de transport.

Le taux de contamination des salles blanches et de l'atmosphère interne des chambres de procédé et/ou de transfert des équipements de fabrication semi-conducteurs est contrôlé en permanence de façon à permettre une réaction rapide sur les procédés de fabrication en cas de pollution.

Il est fait reférence aux documents WO 2006030849, US-A-5697750, JP-A-05109862 et EP-A-17635477.

Entre les diverses étapes de fabrication, les substrats sont isolés dans des enceintes standardisées à ouverture latérale de type FOUP (« Front Opening Unified Pod » en anglais), ou à ouverture par le fond de type SMIF (« Standard Mechanical Actionneur » en anglais), pour être stockés en attente ou pour être acheminés à la prochaine étape de fabrication de semi-conducteurs.

Or, les enceintes de transport et/ou de stockage de substrats sont des environnements poreux qui peuvent, dans certains cas, concentrer les contaminants et en particulier des contaminants organiques, aminés ou acides.

En effet, en sortie des procédés de traitement pour la fabrication de semi-conducteurs, les substrats sont chargés de gaz de procédé. Ces gaz s'échappent des substrats et peuvent charger les parois et l'environnement intérieur des enceintes de transport qui se trouvent ainsi contaminées. Les substrats stockés dans ces enceintes peuvent alors être exposés à ces atmosphères contaminées.

Ces contaminations peuvent être très néfastes pour les substrats, même à l'état de traces de l'ordre du ppb (« parts per billion » en anglais ou billionième en français). Il est donc devenu indispensable d'analyser également l'atmosphère intérieure des enceintes de transport pour détecter les traces de contamination gazeuse afin de pouvoir prendre rapidement des mesures de décontamination qui s'imposent.

On connaît déjà un dispositif pour le contrôle de la contamination des substrats comprenant un analyseur de gaz et des moyens d'interface pour mettre en communication directe l'analyseur de gaz avec l'atmosphère interne des enceintes de transport pour effectuer une analyse en temps réel des gaz.

Ces moyens d'interface comportent un adaptateur conformé pour coopérer avec une enceinte de transport normalisée comprenant un collecteur définissant une enceinte de prélèvement autour de l'ouverture de l'enceinte de transport et autorisant une ouverture au moins partielle de sa porte inférieure. Un orifice latéral permet de connecter l'analyseur de gaz avec l'intérieur de l'enceinte de prélèvement dans le collecteur.

Toutefois, lors de l'ouverture de l'enceinte de transport, l'atmosphère environnante pénètre également dans l'enceinte et dilue la composition enfermée dans celle-ci. Par conséquent, on ne peut obtenir qu'un résultat approximatif sur la réelle composition des gaz et en particulier, sur l'état de contamination de l'enceinte de transport.

Pour améliorer encore la qualité de la mesure des traces de gaz contaminants, l'invention propose une interface pouvant s'intégrer dans un dispositif d'analyse tel qu'une station d'analyse ou une chambre d'entrée/sortie d'équipement de fabrication semi-conducteur, pour effectuer une analyse dans une enceinte de transport et/ou de stockage et pour laquelle le phénomène de dilution est fortement réduit.

A cet effet, l'invention selon la revendication 1 a pour objet une interface d'enceinte de transport comportant une sonde de prélèvement destinée à être reliée à un analyseur de gaz et un actionneur susceptible de s'accoupler à une porte d'accès d'enceinte de transport ,

Le joint d'étanchéité (31) peut être agencé de sorte que le déplacement de l'actionneur dans la position de retrait comprime au moins partiellement le joint d'étanchéité.

L'actionneur peut comporter un plateau pour s'accoupler à la porte, et un vérin pour déplacer le plateau accouplé à ladite porte.

Selon une variante de réalisation, le joint d'étanchéité entoure le vérin.

Selon une autre variante, le joint d'étanchéité est fixé à la face du plateau opposée à celle accouplée à ladite porte.

Selon encore une autre variante, le joint d'étanchéité est fixé à au moins une paroi de ladite base.

Un joint d'étanchéité périphérique peut être disposé dans la zone de contact des bords du couvercle de ladite enceinte avec l'interface.

L'interface peut comporter un joint d'étanchéité supplémentaire apte à isoler le volume compris entre la face du plateau accouplée à la porte et la porte elle-même.

L'interface est susceptible de s'accoupler avec au moins une enceinte de transport normalisée de type SMIF (Standard Mechanical Actionneur) ou de type FOUP (Front Opening Unified Pod).

L'invention a également pour objet un dispositif d'analyse, tel qu'une station d'analyse ou une chambre d'entrée/sortie d'équipement de fabrication semi-conducteur, comprenant au moins une telle interface pour la mesure et le contrôle de l'atmosphère interne des enceintes de transport.

D'autres avantages et caractéristiques apparaîtront à la lecture de la description de l'invention, ainsi que des dessins annexés sur lesquels :
- la figure 1 est une vue schématisée d'un premier mode de réalisation d'une interface selon l'invention dans une position d'accouplement,
- la figure 2 est une vue schématisée de l'interface de la figure 1, dans une position de retrait,
- la figure 3 est une vue schématique d'un second mode de réalisation de l'interface accouplée à une enceinte de transport,
- la figure 4 est une vue schématique d'un troisième mode de réalisation de l'interface accouplée à une enceinte de transport.

Dans les procédés de fabrication de semi-conducteurs ou de microsystèmes électromécaniques (MEMS), les substrats tels que les plaquettes (« wafers ») et les masques sont habituellement transportés et/ou stockés entre les étapes de procédé dans une enceinte de transport et/ou de stockage standardisée à ouverture latérale de type FOUP (« Front Opening Unified Pod ») ou à ouverture par le fond de type SMIF (« Standard Mechanical Actionneur »).

Ces enceintes de transport et/ou de stockage et leur atmosphère intérieure sont à pression atmosphérique d'air ou d'azote.

Les gaz contenus dans l'enceinte peuvent être analysés par un dispositif d'analyse, tel qu'une station d'analyse placée en salle blanche par exemple pour former un poste de contrôle, ou tel qu'une chambre d'entrée/sortie d'équipement de fabrication semi-conducteur, comprenant au moins une interface selon l'invention pour le contrôle de la contamination de substrats ou encore des enceintes elles-mêmes.

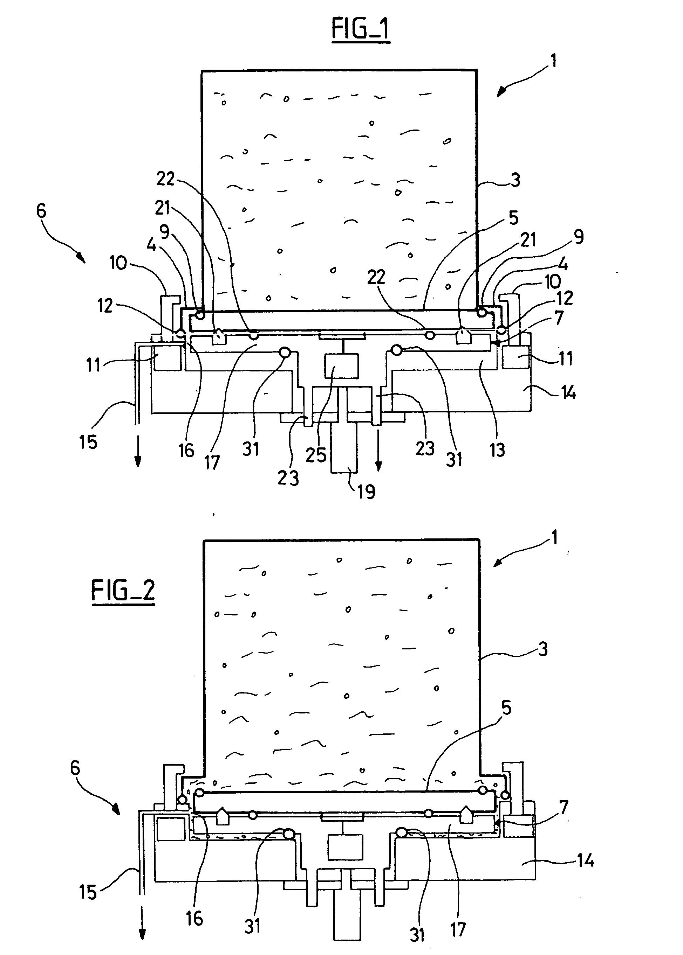

La figure 1 représente une enceinte de transport 1 du type « SMIF » comportant un couvercle 3 avec des bords 4, et pouvant être obturée par une porte d'accès 5 dimensionnée pour l'introduction et l'extraction de substrats.

L'enceinte 1 est assez étanche, mais le niveau d'étanchéité est tel que de légères fuites peuvent se produire à travers un joint d'étanchéité 9 entre le couvercle 3 et la porte 5.

La porte 5 est ouverte ou fermée par le fond après accouplement à une interface d'enceinte 6 via un actionneur 7, comme visible sur la figure 1.

L'interface 6 est susceptible de verrouiller l'accouplement de l'enceinte 1, par exemple par la rotation d'un quart de tour de doigts rotatifs 10 retenant ainsi les bords 4 du couvercle 3.

Ainsi, au moins deux doigts rotatifs 10 sont prévus de part et d'autre du couvercle 3, chacun actionné en rotation par un vérin 11, tel qu'un vérin pneumatique ou électrique.

Avantageusement, l'interface 6 comporte un joint d'étanchéité périphérique 12, disposé dans la zone de contact des bords 4 du couvercle 3 de l'enceinte 1 avec l'interface 6.

Le joint 12 permet d'isoler le volume compris entre l'enceinte 1 et l'interface 6 avec l'atmosphère extérieure à l'interface 6 accouplée au couvercle 3. Le joint 12 est comprimé au moins partiellement par les doigts rotatifs 10 de retenue.

L'interface 6 selon l'invention comporte en outre une sonde de prélèvement 15 dont un orifice d'aspiration 16 débouche dans un espace libre 13 délimité par la base 14 et ses parois périphériques (figure 1).

La sonde de prélèvement 15, réalisée sous forme d'une canalisation de petit diamètre (de l'ordre de quelques millimètres), est destinée à être reliée à un analyseur de gaz (non représenté) pour prélever le gaz à analyser et pour le diriger vers l'analyseur.

On peut prévoir un dispositif de pompage sur la canalisation pour acheminer le gaz vers l'analyseur et former ainsi une sonde de prélèvement 15 de type « renifleur ».

L'actionneur 7 de l'interface 6 est monté mobile en déplacement dans l'espace libre 13 entre une position d'accouplement (figure 1) et une position de retrait (figure 2).

Avantageusement, on prévoit que l'actionneur 7 possède un plateau 17 pour s'accoupler à la porte 5.

Le plateau 17 présente des dimensions approximativement équivalentes à celles de la porte d'accès 5 et, est avantageusement adapté pour positionner l'enceinte 1 sur l'actionneur 7, par exemple par l'intermédiaire de picots de positionnement 21.

L'accouplement du plateau 17 avec la porte 5 peut être verrouillé par la rotation d'un quart de tour de moyens de verrouillage actionnés par un vérin 25.

Avantageusement, un joint d'étanchéité 22 est disposé entre le plateau 17 de l'actionneur 7 et l'enceinte de transport 1 accouplés pour isoler le volume compris entre la face du plateau 17 et la porte 5.

L'actionneur 7 possède en outre un vérin 19, tel qu'un vérin à actionnement électrique, pour déplacer le plateau 17 et ainsi la porte 5 accouplée à celui-ci vers le bas selon la direction schématisée par la flèche 27, dans l'espace libre 13 de l'interface 6.

Des guides 23 sont prévus pour guider le déplacement du plateau 17 accouplé à la porte 5 dans l'interface 6.

L'actionneur 7 est donc susceptible de s'accoupler à la porte d'accès 5 de l'enceinte de transport 1 dans une position d'accouplement et susceptible de déplacer cette porte 5 de l'enceinte 1 vers la base 14 de l'interface 6 dans une position de retrait dans laquelle le volume de gaz à analyser contenu dans l'enceinte de transport 1 est accessible par la sonde 15.

Il est important que la course de déplacement du plateau 17 soit la plus petite possible, de façon à permettre l'accès du volume de gaz à analyser à la sonde 15 tout en limitant au maximum la quantité de gaz supplémentaire apporté intrinsèquement par l'ouverture de l'enceinte 1.

Ainsi, la quantité de gaz supplémentaire est la plus petite possible de sorte que la dilution des gaz à mesurer soit limitée.

En outre, il est judicieux que d'une part, la conductance entre les extrémités du plateau 17 et les parois de l'espace libre 13 et d'autre part, la force et la vitesse de déplacement du plateau 17, soient prévus pour minimiser le flux de fuite de gaz entrant dans le volume de gaz à analyser lors du déplacement du plateau 17 de la position d'accouplement à la position de retrait.

Ainsi, le déplacement du plateau 17 vers le bas permet de chasser l'air contenu sous le plateau 17 dans l'espace libre 13 dans la position d'accouplement du plateau 17, limitant ainsi davantage la dilution du volume de gaz à mesurer.

Afin de minimiser toute dilution des gaz à l'intérieur de l'enceinte 1, l'interface 6 selon l'invention comporte en outre au moins un joint d'étanchéité 31 agencé de manière à assurer au moins dans la position de retrait (figure 2), une étanchéité entre l'actionneur 7 et la base 14 de façon à isoler le volume de gaz à analyser.

De préférence, on prévoit un joint d'étanchéité 31 de forme torique, à lèvres ou chanfreiné.

Pour le mode de réalisation des figures 1 et 2, ce joint d'étanchéité 31 est fixé à la face du plateau 17 opposée à celle accouplée à la porte 5 de l'enceinte 1.

Le joint d'étanchéité 31 est agencé de sorte que le déplacement de l'actionneur 7 dans la position de retrait comprime au moins partiellement le joint d'étanchéité 31.

Lorsque l'interface 6 est en fonctionnement pour la réalisation d'une analyse de gaz, une enceinte de transport 1 est d'abord placée sur le plateau 17 de l'interface 6, via les picots de positionnement 21, dans la position d'accouplement.

L'interface 6 verrouille alors l'accouplement de l'enceinte 1 par la rotation des doigts rotatifs 10 sur les bords 4 du couvercle 3 de l'enceinte 1, comprimant en même temps au moins partiellement le joint 12 placé entre l'interface 6 et le couvercle 3.

Le vérin 25 actionne ensuite les moyens de verrouillage de l'accouplement du plateau 17 avec la porte 5 et compriment partiellement le joint d'étanchéité 22 entre le plateau 17 et l'enceinte de transport 1 accouplés.

Puis, le vérin 19 déplace l'actionneur 7 vers le bas dans l'espace libre 13 de la position d'accouplement (figure 1) à la position de retrait (figure 2) le long des guides 23.

Le déplacement de l'actionneur 7 vers la position de retrait chasse simultanément l'air contenu sous le plateau 17 vers le bas.

En fin de course du vérin 19, l'actionneur 7 comprime partiellement le joint d'étanchéité 31 isolant ainsi le volume de gaz à mesurer représenté par le motif à points sur les figures 1 et 2.

Le volume de gaz à analyser est ainsi isolé de l'atmosphère environnante extérieure à celle comprise dans l'enceinte 1 accouplée à l'interface 6 et ne peut donc plus être dilué pendant la réalisation de la mesure.

La sonde 15 prélève alors le gaz à analyser et le dirige vers l'analyseur comme illustré sur la figure 2 où l'interface 6 est en fonctionnement d'analyse de contamination.

Pour réaliser une analyse en temps réel, c'est-à-dire dans un laps de temps très court et de manière suffisamment sensible pour détecter de très faibles niveaux de contamination gazeuse à l'état de trace (de l'ordre du ppb), une possibilité est d'utiliser un analyseur de gaz dans lequel on mesure la mobilité des ions par exemple selon le principe de l'instrumentation IMS (« Ion Mobility Spectrometer » en anglais) ou selon la technologie IAMS (« Ion Attachment Mass Spectrometer » en anglais).

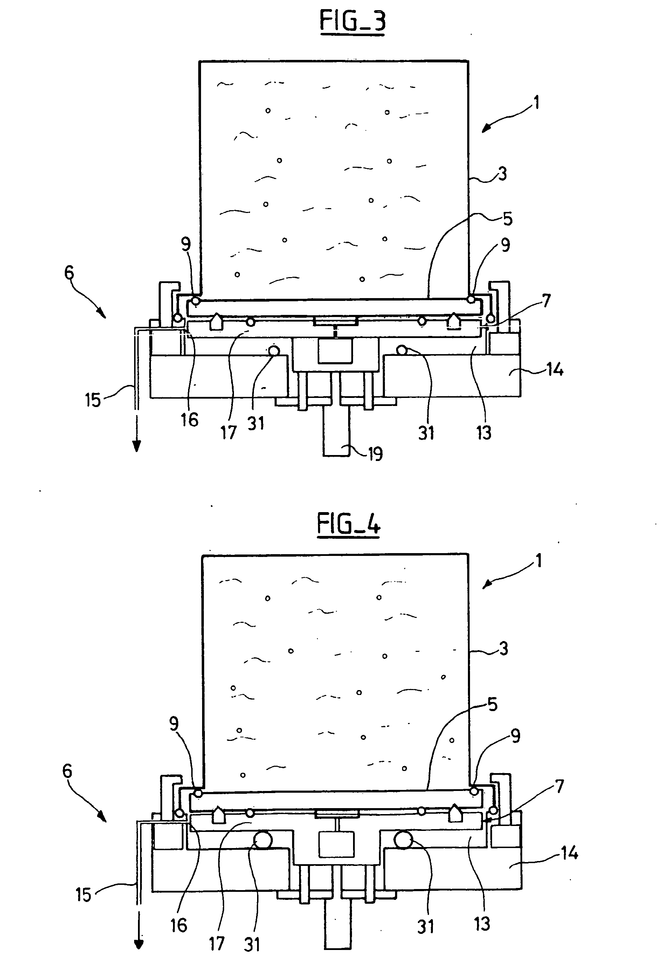

Les figures 3 et 4, illustrent deux autres modes de réalisation dans lesquelles le joint d'étanchéité 31 est placé entre la face du plateau 17 opposée à celle accouplée à la porte 5 et la base 14.

Dans le second mode de réalisation de la figure 3, le joint d'étanchéité 31 est fixé à au moins une paroi de la base 14 de l'interface 6. Le volume de gaz à mesurer est ainsi isolé en fin de course du vérin 19 dans la position de retrait de l'actionneur 7.

Dans le troisième mode de réalisation illustré sur la figure 4, le joint d'étanchéité 31 est en contact permanent avec d'une part la face du plateau 17 opposée à celle accouplée à la porte 5 de l'enceinte 1 et d'autre part avec au moins une paroi de la base 14 de l'interface 6 vers laquelle le plateau 17 est déplacé dans la position de retrait.

Dans ce mode de réalisation, le volume de gaz à mesurer est isolé dès la position d'accouplement de l'interface 6 avec l'enceinte 1 jusqu'à la position de retrait de l'actionneur 7.

De façon alternative, on prévoit que le joint d'étanchéité 31 est placé dans un angle formé sur la périphérie intérieure de la paroi de la base 14.

On peut en outre prévoir que le joint d'étanchéité 31 entoure le vérin 19 pour confiner à l'extérieur du volume de gaz à mesurer d'éventuelles particules qui seraient déplacées par le mouvement du vérin 19.

On comprend que grâce à une interface 6 comportant un joint d'étanchéité 31 apte à isoler le volume de gaz à analyser, il est possible de faire une analyse en temps réel des traces de gaz de contaminants sans dilution importante du volume de gaz à mesurer par l'atmosphère qui environne les enceintes de transport 1.

Cette disposition est simple à mettre en oeuvre et sans risque de contamination supplémentaire des substrats induite par une pièce en mouvement.

D'autre part, l'interface 6 permet de réaliser une mesure sans à avoir à enlever les substrats de l'enceinte 1 qui les contient et sans modification de la structure de l'enceinte de transport 1 normalisée.

Sans sortir du cadre de la présente invention, on peut prévoir plusieurs interfaces 6 associées à autant de sondes de prélèvement 15 et reliées à un seul dispositif d'analyse comportant un analyseur de gaz ainsi qu'un système de multiplexage par exemple.

## Revendications

1. Interface d'enceinte de transport (1) comportant une sonde de prélèvement (15) dé gaz à analyser en contamination destinée à être reliée à un analyseur de gaz, et un actionneur (7) comportant un plateau (17) susceptible de s'accoupler à une porte d'accès (5) d'enceinte de transport (1) dans une position d'accouplement et susceptible de déplacer la porte (5) vers une base (14) de l'interface (6) dans une position de retrait dans laquelle le volume de gaz à analyser contenu dans l'enceinte de transport (1) est accessible par la sonde de prélèvement (15), **caractérisée en ce qu'**elle comporte au moins un joint d'étanchéité (31) de forme torique, à lèvres ou chanfreiné, en contact permanent avec d'une part la face du plateau (17) opposée à celle accouplée à la porte (5) et d'autre part avec au moins une paroi de la base (14), et agencé de manière à assurer au moins dans la position de retrait, une étanchéité entre l'actionneur (7) et ladite base (14) de façon à isoler le volume de gaz à analyser.

2. Interface selon la revendication 1, dans laquelle le joint d'etanchéité (31) est agencé de sorte que le déplacement de l'actionneur (7) dans la position de retrait comprime au moins partiellement le joint d'étanchété (31).

3. Interface selon l'une des revendications 1 ou 2, dans laquelle l'actionneur (7) comporte un vérin (19) pour déplacer le plateau (17) accouplé à la porte (5).

4. Interface selon la revendication 3. dans laquelle le joint d'étanchéité (31) entoure le vérin (19).

5. Interface selon l'une des revendications 3 ou 4. dans laquelle le joint d'etanchéité (31) est fixé à la face du plateau (17) opposée à celle accouplée à la porte (5).

6. Interface selon l'une des revendications 3 ou 4, dans laquelle le joint d'étanchéité (31) est fixé à au moins une paroi de la base (14),

7. Interface selon l'une des revendications précédentes, dans laquelle un joint d'etanchéité périphérique (12) est disposé dans la zone de contact des bords (4) du couvercle (3) de l'enceinte (1) avec l'interface (6).

8. Interface selon l'une des revendications précédentes, comportant un joint d'étanchéité (22) supplementaire apte à isoler le volume compris la face du plateau (17) accouplée à la porte (5) et la porte (5) elle-même.

9. Interface selon l'une des revendications précédentes susceptible de s'accoupler avec au moins une enceinte de transport normalisée de type SMIF (Standard Mechanical Actionneur) ou de type FOUP (Front Opening Unified Pod).

10. Dispositif d'analyse comportant au moins une interface selon l'une des revendications précédentes.

## Claims

1. Interface for a transport pod (1) comprising a probe (15) for sampling gas to be analysed for contamination, the probe being intended to be connected to a gas analyser, and an actuator (7) comprising a plate (17) capable of coupling to a door (5) for accessing the transport pod (1) in a coupling position and capable of moving the door (5) towards a base (14) of the interface (6), into a set-back position in which the volume of gas to be analysed, contained in the transport pod (1), is accessible to the sampling probe (15), **characterized in that** it comprises at least one toric, lipped or tapered seal (31), which makes permanent contact, on the one hand, with that face of the plate (17) which is opposite the face coupled to the door (5) and, on the other hand, with at least one wall of the base (14), and arranged so as, at least in the set-back position, to seal between the actuator (7) and said base (14), so as to isolate the volume of the gas to be analysed.

2. Interface according to Claim 1, in which the seal (31) is arranged so that the movement of the actuator (7) into the set-back position at least partially compresses the seal (31).

3. Interface according to either of Claims 1 and 2, in which the actuator (7) comprises a mechanical actuator (19) for moving the plate (17) coupled to the door (5).

4. Interface according to Claim 3, in which the seal (31) surrounds the mechanical actuator (19).

5. Interface according to either of Claims 3 and 4, in which the seal (31) is fixed to that face of the plate (17) which is opposite the face coupled to the door (5).

6. Interface according to either of Claims 3 and 4, in which the seal (31) is fixed to at least one wall of the base (14).

7. Interface according to one of the preceding claims, in which a peripheral seal (12) is placed in the contact region of the edges (4) of the cover (3) of the pod (1) with the interface (6).

8. Interface according to one of the preceding claims, comprising an additional seal (22) able to isolate the volume located between that face of the plate (17) which is coupled to the door (5) and the door (5) itself.

9. Interface according to any one of the preceding claims, capable of coupling with at least one standardized SMIF (standard mechanical interface) or FOUP (front opening unified pod) transport pod.

10. Analysis device comprising at least one interface according to one of the preceding claims.

## Patentansprüche

1. Schnittstelle eines Transportbehälters (1), umfassend eine Sonde (15) zur Entnahme eines zu analysierenden kontaminierten Gases, die dazu bestimmt ist, mit einem Gasanalysator verbunden zu werden, und ein Betätigungselement (7), umfassend eine Platte (17), die mit einer Zugangstür (5) zu dem Transportbehälter (1) in einer Kupplungsposition gekuppelt werden kann und die Tür (5) zu einer Basis (14) der Schnittstelle (6) in eine eingefahrene Position verschieben kann, in der das zu analysierende Gasvolumen, das in dem Transportbehälter (1) enthalten ist, für die Entnahmesonde (15) zugänglich ist, **dadurch gekennzeichnet, dass** sie mindestens eine Dichtung (31) in Ringform mit Lippen oder einer Abschrägung umfasst, die in ständigem Kontakt mit einerseits der Seite der Platte (17), die der mit der Tür (5) gekuppelten gegenüber liegt, und andererseits mit mindestens einer Wand der Basis (14) ist, und die derart angeordnet ist, dass sie mindestens in der eingefahrenen Position eine Abdichtung zwischen dem Betätigungselement (7) und der Basis (14) gewährleistet, um das zu analysierende Gasvolumen zu isolieren.

2. Schnittstelle nach Anspruch 1, bei der die Dichtung (31) derart angeordnet ist, dass die Verschiebung des Betätigungselements (7) in die eingefahrene Position zumindest teilweise die Dichtung (31) zusammendrückt.

3. Schnittstelle nach einem der Ansprüche 1 oder 2, bei der das Betätigungselement (7) einen Zylinder (19) umfasst, um die mit der Tür (5) gekuppelte Platte (17) zu verschieben.

4. Schnittstelle nach Anspruch 3, bei der die Dichtung (31) den Zylinder (19) umgibt.

5. Schnittstelle nach Anspruch 3 oder 4, bei der die Dichtung (31) auf der Seite der Platte (17) montiert ist, die der an die Tür (5) gekuppelten gegenüber liegt.

6. Schnittstelle nach einem der Ansprüche 3 oder 4, bei der die Dichtung (31) an mindestens einer Wand der Basis (14) befestigt ist.

7. Schnittstelle nach einem der vorhergehenden Ansprüche, bei der eine Umfangsdichtung (12) in der Kontaktzone der Ränder (4) des Deckels (3) des Behälters (1) mit der Schnittstelle (6) angeordnet ist.

8. Schnittstelle nach einem der vorhergehenden Ansprüche, umfassend eine zusätzliche Dichtung (22), die geeignet ist, das Volumen, das zwischen der Seite der Platte (17), die der Tür (5) gegenüber liegt, und der Tür (5) selbst enthalten ist, zu isolieren.

9. Schnittstelle nach einem der vorhergehenden Ansprüche, die geeignet ist, mit mindestens einem genormten Transportbehälter des Typs SMIF (Standard Mechanical Actionneur) oder des Typs FOUP (Front Opening Unified Pod) gekuppelt zu werden.

10. Analyseeinrichtung, umfassend mindestens eine Schnittstelle nach einem der vorhergehenden Ansprüche.
